# EUROPÄISCHE PATENTANMELDUNG

(11) **EP 1 217 880 A2**
(43) Veröffentlichungstag der Anmeldung: **26.06.2002**
(21) Anmeldenummer: 01129836.1
(22) Anmeldetag: 14.12.2001
(51) Int. Cl.: H05K 7/20

(54) **Vorrichtung zur Kühlung von Bauteilen**

(30) Priorität: 21.12.2000 DE 10063874
(71) Anmelder: SIEMENS AKTIENGESELLSCHAFT, 80333 München (DE)
(72) Erfinder: Laufer, Martin, 97907 Hasloch (DE); Riedl, Ute, 35606 Solms/Oberndorf (DE)

(57) **Zusammenfassung**

Zur Kühlung von elektronischen Bauteilen auf einer Platine (2), die sich innerhalb einer (EMV-)Abschirmung (3) befindet, wobei die Abschirmung (3) innerhalb eines Gehäuses (1) liegt, wird ein Teilluftstrom eines Lüfters (5) in der Gehäusewand mittels eines Lufleitkanals (13) in die Abschirmung (3) geführt. Die Kühlung ist sehr effektiv. Bei dieser Lösung kann auf die bekannten wärmeleitenden Elemente zwischen den Bauteilen (4) und der Abschirmung (3) verzichtet werden.

## Beschreibung

Die Erfindung bezieht sich auf eine Anordnung zur Kühlung von elektronischen Bauteilen auf einer Platine, die zum Schutz vor elektromagnetischer Strahlung in eine metallische Abschirmung eingebettet ist.

Elektronische Bauteile, insbesondere hochintegrierte Schaltungen, erzeugen im Betrieb Wärme, die abgeleitet werden muss, damit die Bauteile nicht zerstört werden. Dazu wird die sich erwärmende Luft im Gehäuse, in denen sich diese Bauteile befinden, mittels eines Lüfters laufend durch kühlere Umgebungsluft ersetzt. Nicht unbedingt ausreichend ist diese Methode, wenn die Platine mit den Bauteilen noch mit einer metallischen Abschirmung innerhalb des Gehäuses versehen ist, um die elektromagnetische Verträglichkeit (EMV) sicherzustellen. Eine solche unmittelbare Abschirmung ist selbst bei metallischen Gehäusen notwendig, die an sich auch eine gewisse Abschirmung bewirken. Diese reicht aber allein nicht aus, da in der Regel ein Gehäuse viele Öffnungen für Zuleitungen und Bedienelemente aufweist, durch die die elektromagnetische Strahlung eindringen kann. Die metallische Abschirmung muss nämlich, um voll wirksam zu sein, ausreichend dicht sein, sie darf also keine allzu großen Öffnungen aufweisen. Eine solche dichte, unmittelbar an der Platine angeordnete Abschirmung hat allerdings auch zur Folge, dass die Luft zwischen der Platine und der Abschirmung nicht am allgemeinen Luftaustausch im Gehäuse teilnimmt und damit die Wärmeabfuhr reduziert ist.

Es wurde daher schon vorgeschlagen, zwischen den zu kühlenden Bauteilen und der Abschirmung ein wärmeleitendes Kissen zu plazieren, so dass die vom Bauteil erzeugte Wärme auf die Abschirmung übertragen wird, die wiederum durch den von außen vorbeistreichenden Luftstrom gekühlt wird.

Die Erfindung geht von dem Problem aus, in einfacher Weise die Kühlung von Bauteilen auf einer Platine innerhalb einer Abschirmung zu verbessern.

Dazu wird vorgeschlagen, dass bei einer Anordnung zur Kühlung gemäß dem Oberbegriff des Anspruchs 1 die Abschirmung mindestens eine Lufteintritts- und mindestens eine Luftaustrittsöffnung aufweist, wobei die erstgenannte über einen Luftleitkanal mit einem Lüfter verbunden ist.

Bei einer Abschirmung, die aus zwei parallel und im geringen Abstand zur Platine verlaufenden Decken besteht, die über Seitenwände zu einem weitgehend geschlossenen Kasten miteinander verbunden sind, erreicht man eine optimale und reibungsarme Verteilung des Luftstroms über die Platinenoberfläche, wenn die Lufteintritts- und Luftaustrittsöffnung in den Seitenwänden ausgebildet sind.

Häufig werden zu kühlende Bauteile auf beiden Seiten der Platine angeordnet. In einem solchen Fall ist es von Vorteil, wenn der Luftleitkanal zwei Teilkanäle aufweist, wobei der eine Teilkanal in den Raum zwischen der einen Seite der Platine und der Abschirmung und der andere Teilkanal in den Raum zwischen der anderen Seite der Platine und der Abschirmung führt.

Häufig besteht die Abschirmung aus Metallblechen, wobei die Abschnitte der Seitenwand auf der einen Seite der Platine über Laschen verfügen, die durch nahe beieinander liegende Löcher in der Platine hindurchgesteckt sind und die mit entsprechenden Laschen der Abschirmung auf der anderen Seite der Platine reib- und formschlüssig verbunden sind. Ein Teil der Platine reicht dabei über die Abschirmung hinaus. Insbesondere bei dieser Bauweise bietet es sich an, dass ein den Luftleitkanal bildendes Bauteil auf diesen Abschnitt der Platine aufgesteckt ist. Das Bauteil verfügt dazu über einen Schlitz, in dem die Platine steckt, die dadurch gegebenenfalls gleichzeitig eine Trennwand zwischen den beiden Teilkanälen bildet.

Es existieren auch Abschirmungen, die aus einem metallisierten Kunststoff bestehen. In einem solchen Fall bietet es sich an, den Luftleitkanal einstückig mit der Abschirmung auszubilden. Dies hat den Vorteil, dass Abschirmung und Luftleitkanal in einem Arbeitsgang hergestellt und gleichzeitig auf der Platine plaziert werden können. Eine konkrete Ausführung sieht vor, dass die Abschirmung aus zwei flachen metallisierten Halbwannen besteht, die zu beiden Seiten der Platine angeordnet sind, und dass der Luftleitkanal von zwei Halbschalen gebildet ist, die jeweils mit einer Halbwanne einstückig verbunden sind.

Ein typischerweise zur Kühlung von elektronischen Bauteilen eingesetzter Lüfter besteht aus einem Rahmen, in dessen Zentrum ein Lüftermotor angeordnet ist, der ein Lüfterrad antreibt, dessen Schaufeln in einem kreisringförmigen Freiraum zwischen dem Rahmen und dem Lüftermotor laufen. Ein solcher Lüfter befindet sich unmittelbar vor den Eingang des Luftleitkanals, wobei nur ein Teil des Freiraumes abgedeckt ist. Dies hat zur Folge, dass der Teil des Luftstroms, der durch den nicht abgedeckten Teil des Freiraums gesaugt wird, in das Gehäuse gelangt und dort weitere Bauteile außerhalb der Abschirmung kühlt. Ein einziger Lüfter kann auf diese Weise sowohl zum Luftaustausch in der Abschirmung als auch zum Luftaustausch im Gehäuse eingesetzt werden.

Der vom Eingang des Luftleitkanals abgedeckte Bereich des Freiraums dient der Belüftung des Raumes innerhalb der Abschirmung. Damit die beiden Teilräume ober- und unterhalb der Platine in etwa mit der gleichen Luftmenge versorgt werden, muss dafür gesorgt werden, dass die Überschneidung der Querschnittsflächen der Eingänge der Teilkanäle mit der Querschnittsfläche des Freiraumes in etwa gleich groß sind.

Vorzugsweise ist der Lüfter in bzw. an einer Öffnung in der Wand eines Gehäuses befestigt, das die Platine mit der Abschirmung und weitere, insbesondere mechanisch arbeitende Bauteile aufnimmt, wobei der nicht vom Luftleitkanal abgedeckte Freiraum des Lüfters der Kühlung dieser weiteren Bauteile dient.

Im Folgenden soll anhand eines Ausführungsbeispieles die Erfindung näher verdeutlicht werden. Dazu zeigen
- Fig. 1: einen Schnitt durch ein Gehäuse mit einer Platine in einer Abschirmung, mit einem Lüfter und einem Luftleitkanal,
- Fig. 2: Eine konkrete Ausführung in einer Explosionsdarstellung.

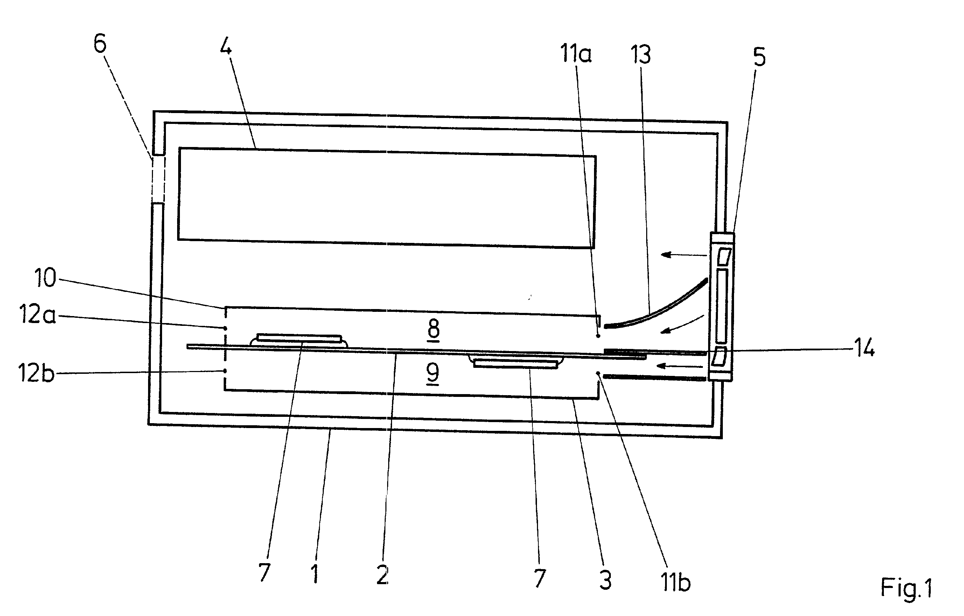

Zunächst wird auf die Fig. 1 Bezug genommen: Im unteren Teil des Gehäuses 1 befindet sich eine Platine 2 innerhalb einer Abschirmung 3. Darüber befindet sich z.B. ein CD-Player 4, der hier nur schematisch angedeutet ist. In der Rückwand des Gehäuses 1 ist ein Lüfter 5 befestigt. In der Gehäusewand befinden sich mehrere Öffnungen, so z.B. ein Einführschlitz 6 zum Einführen einer CD. Die Größe und Anzahl der Öffnungen lassen es nicht zu, das Gehäuse selbst, obwohl es aus Metall besteht, als EMV-Abschirmung zu nutzen. Daher liegt die Platine 2 zumindest mit den Bereichen, die die empfindlichen Bauteile 7 tragen, innerhalb der (EMV-) Abschirmung 3, die möglichst wenige und dann auch nur kleine Öffnungen aufweist.

Zur erfindungsgemäßen Belüftung der Teilräume 8, 9 innerhalb der Abschirmung 3 ober- und unterhalb der Platine 2 weisen die Seitenwände 10 der Abschirmung 3 Ein- und Austrittsöffnungen 11a, 11b, 12a, 12b auf. An den Eintrittsöffnungen 11a, 11b schließt ein Luftleitkanal 13, der den Abstand zwischen der Seitenwand 10 und dem Lüfter 5 in der Rückwand des Gehäuses 1 überbrückt. Die Eingangsöffnung des Luftleitkanals deckt den Lüfter nicht vollständig ab, sondern lässt einen Teil frei, so dass ein Teil der vom Lüfter 5 angesaugten Luftmenge in das Innere des Gehäuses 1 gelangt.

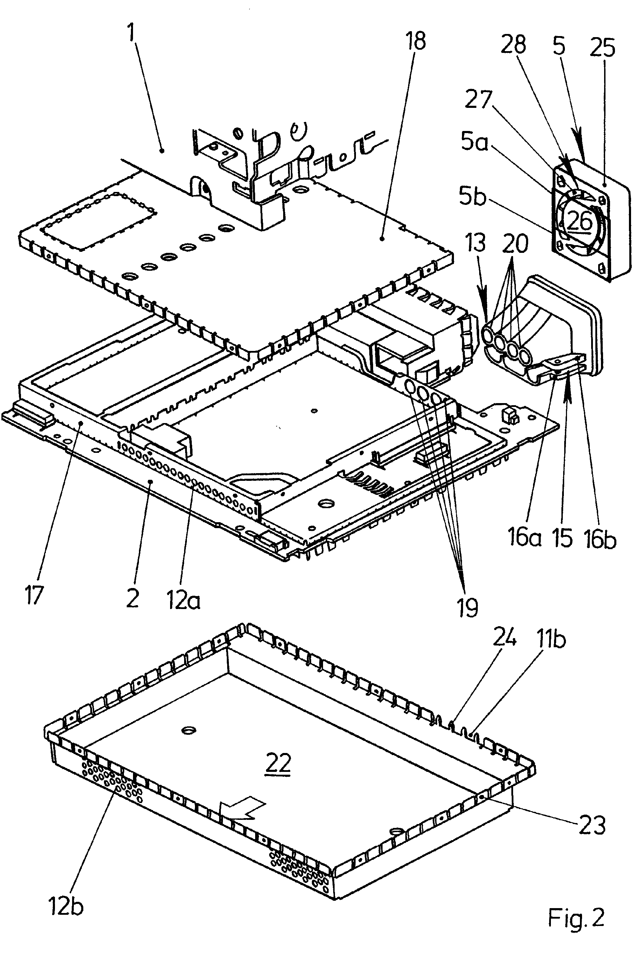

Wie der Darstellung des Lüfters 5 und des Luftleitkanals 13 in der Fig. 2 entnommen werden kann, ist der Eingangsquerschnitt des Luftleitkanals 13 reckteckig, wodurch etwa 2/3 des Lüfters 5 abgedeckt sind. Die Höhe des Luftleitkanals 13 verringert sich zur Abschirmung 3 hin, indem die obere Wand des Luftleitkanals 13 abfallend verläuft. Innerhalb des Luftleitkanals befindet sich eine waagerecht, d. h parallel zur Platine verlaufende Trennwand 14, die den Luftleitkanal in zwei Teilkanäle mit unterschiedlichen Eingangsquerschnitten aufteilt, deren Projektionen auf den Lüfter als Rechtecke 5a, 5b dargestellt sind. Zwar ist die Querschnittsfläche des Eingangs des oberen Teilkanals in etwa doppelt so groß wie die des Eingangs des unteren Teilkanals. Trotzdem gelangt eine gleich große Luftmenge in beide Teilkanäle, da die Bereiche in jedem Teilkanal, die von den Lüfterschaufeln 27 überstrichen werden, gleich groß sind.

Unterhalb der Trennwand 14 befindet sich ein Schlitz 15 im Luftleitkanal 13, der es ermöglicht, diesen auf die Platine 2 aufzustecken. Außerdem befindet sich ober- und unterhalb des Schlitzes 15 jeweils ein Flügel 16a, 16b mit Schraublöchern, die mit einem Loch in der Platine 2 korrespondieren, so dass der Luftleitkanal 13 mit der Platine 2 verschraubt werden kann.

Fig. 2 zeigt als Ganzes eine Explosionsdarstellung einer Platine 2 mit einer Abschirmung 3 und einer Anordnung zur Belüftung.

Die Platine 2 trägt in ihrem mittleren Bereich elektronische Bauteile (die in dieser Darstellung nicht gezeigt sind), der von einem Rahmen 17 aus Metall umgeben ist, der die Seitenwand 10 der Abschirmung 3 oberhalb der Platine 2 bildet. Dieser Rahmen 17 wird von einer Decke 18 geschlossen. Auf der Seite des Rahmens 17, der der Rückwand des Gehäuses 1 zugewandt ist, befinden sich vier runde Löcher 19 als Eintrittsöffnungen 11a, die mit entsprechend geformten Ausgängen 20 des oberen Teilkanals korrespondieren. An der gegenüberliegende Seite befindet sich eine Vielzahl von kleineren Löchern als Austrittsöffnungen 12a, deren Gesamtquerschnittsfläche der Gesamtquerschnittsfläche der Eintrittsöffnungen entspricht.

Eine Vielzahl von Laschen, die in der Darstellung nicht zu erkennen sind, greifen durch Öffnungen in der Platine 2 hindurch und ragen auf der anderen Seite der Platine hervor. Die andere Hälfte der Abschirmung ist eine Blechwanne 22, deren Rand ebenfalls mit Laschen 23 versehen sind, die mit den durchgesteckten Laschen form- und reibschlüssig verbunden werden, so dass sich eine geschlossene Abschirmung 3 bildet. Zur Bildung der Eintrittsöffnungen 11b für den unteren Teilkanal sind einige Laschen 24 schmaler ausgeführt als die anderen, so dass der Abstand zwischen ihnen größer ist. Die Austrittsöffnungen 12b werden wiederum durch eine Vielzahl von kleinen Löchern dargestellt.

Am oberen Bildrand ist ein Teil des Gehäuses 1 dargestellt, das die Platine 2 mit der Abschirmung 3 aufnimmt und in dessen Rückwand sich der Lüfter 5 befindet. Dieser besteht aus einem Rahmen 25, in dessen Zentrum ein Lüftermotor 26 angebracht ist. Die Schaufeln 27 des Lüfters sind unmittelbar am Rotor befestigt und laufen in einem kreisringförmigen Freiraum 28 zwischen dem Rahmen 25 und dem Lüftermotor 27.

## Patentansprüche

1. Anordnung zur Kühlung von elektronischen Bauteilen auf einer Platine, die zum Schutz vor elektromagnetischer Strahlung in eine metallische Abschirmung eingebettet ist, **dadurch gekennzeichnet, dass** die Abschirmung (3) mindestens eine Lufteintritts- und mindestens eine Luftaustrittsöffnung (11a, 11b; 12a, 12b) aufweist, wobei die erstgenannte über einen Luftleitkanal (13) mit einem Lüfter (5) verbunden ist.

2. Anordnung zur Kühlung nach Anspruch 1, **dadurch gekennzeichnet, dass** die Abschirmung (3) aus zwei parallel und im geringen Abstand zur Platine verlaufenden Decken (18) besteht, die über Seitenwände (10) zu einem weitgehend geschlossenen Kasten miteinander verbunden sind, und dass die Öffnungen (11a, 11b; 12a, 12b) in den Seitenwänden (10) ausgebildet sind.

3. Anordnung zur Kühlung nach Anspruch 1 oder 2, **dadurch gekennzeichnet, dass** der Luftleitkanal (13) zwei Teilkanäle aufweist, wobei der eine Teilkanal in den Raum zwischen der einen Seite der Platine (2) und der Abschirmung (3) und der andere Teilkanal in den Raum zwischen der anderen Seite der Platine (2) und der Abschirmung (3) führt.

4. Anordnung zur Kühlung nach Anspruch 1, 2 oder 3, **dadurch gekennzeichnet, dass** ein den Luftleitkanal (13) bildendes Bauteil auf einem Abschnitt der Platine (2) aufgesteckt ist, der seitlich aus der Abschirmung (3) herausragt.

5. Anordnung zur Kühlung nach Anspruch 1, 2 oder 3, **dadurch gekennzeichnet, dass** die Abschirmung (3) aus einem metallisierten Kunststoff besteht und dass der Luftleitkanal (13) einstückig mit der Abschirmung (3) gebildet ist.

6. Anordnung zur Kühlung nach Anspruch 5, **dadurch gekennzeichnet, dass** die Abschirmung (3) aus zwei flachen Halbwannen besteht, die zu beiden Seiten der Platine (2) angeordnet sind, und dass der Luftleitkanal (13) von zwei Halbschalen gebildet ist, die jeweils mit einer Halbwanne einstückig verbunden sind.

7. Anordnung zur Kühlung nach Anspruch 1, 2 oder 3, **dadurch gekennzeichnet, dass** der Lüfter (5) aus einem Rahmen (25) besteht, in dessen Zentrum der Lüftermotor (26) angeordnet ist, der ein Lüfterrad antreibt, dessen Schaufeln (27) in einem kreisringförmigen Freiraum (28) zwischen dem Rahmen (25) und dem Lüftermotor (26) laufen, wobei der Eingang des Luftleitkanals (13) unmittelbar vor dem Lüfter (5) liegt und nur einen Teil des Freiraumes (28) abdeckt.

8. Anordnung zur Kühlung nach Anspruch 7, **dadurch gekennzeichnet, dass** die Überschneidung der Querschnittsflächen der Eingänge der Teilkanäle mit der Querschnittsfläche des Freiraumes (28) in etwa gleich groß sind.

9. Anordnung zur Kühlung nach Anspruch 7 oder 8, **dadurch gekennzeichnet, dass** der Lüfter in bzw. an einer Öffnung in der Wand eines Gehäuses (1) befestigt ist, das die Platine (2) mit der Abschirmung (3) und weitere insbesondere mechanisch arbeitende Bauteile (4) aufnimmt, und dass der nicht vom Luftleitkanal (13) abgedeckte Freiraum (28) des Lüfters (5) der Kühlung dieser weiteren Bauteile (4) dient.
